# EUROPÄISCHE PATENTSCHRIFT

(11) **EP 2 235 551 B1**
(45) Veröffentlichungstag und Bekanntmachung des Hinweises auf die Patenterteilung: **18.01.2012**
(21) Anmeldenummer: 08871360.7
(22) Anmeldetag: 26.11.2008
(51) Int. Cl.: G01R 33/02, G01R 33/00, G01D 11/24, G01P 3/42

(54) **MAGNETFELDSENSOR**
MAGNETIC FIELD SENSOR
CAPTEUR DE CHAMP MAGNÉTIQUE

(30) Priorität: 21.01.2008 DE 102008005315; 03.07.2008 DE 202008009002 U
(43) Veröffentlichungstag der Anmeldung: 06.10.2010
(73) Patentinhaber: Robert Bosch GmbH, 70442 Stuttgart (DE)
(72) Erfinder: STEINBRINK, Ronald, 99086 Erfurt (DE); SCHULZE, Steffen, 99817 Eisenach (DE); MATTHIE, Daniel, 99817 Eisenach (DE); BEYERSDORFER, Jan, 99819 Foertha (DE)
(86) Internationale Anmeldenummer: PCT/EP2008/066231
(87) Internationale Veröffentlichungsnummer: WO 2009/092479

(56) Entgegenhaltungen:
- EP-A1- 0 694 766
- WO-A2-2005/080922
- DE-A1- 19 612 765
- DE-A1- 19 653 639
- FR-A1- 2 864 700

## Beschreibung

### Stand der Technik

Die Erfindung geht aus von einem Magnetfeldsensor nach der Gattung des unabhängigen Anspruchs.

Aus der DE 101 29 222 A1 ist ein Magnetfeldsensor bekannt, dessen Sensorelement auf einem Träger aus Metall sitzt und in einer festen Position zu einem rotierenden Geberelement durch eine Umspritzung mit Kunststoff fixiert ist. Die Position des Sensorelementes ergibt sich durch einen Anschlag, welcher den Abstand zwischen dem Sensor und dem Encoder definiert, wobei weder dieser Abstand noch die Winkelposition des Sensors zum Encoder veränderbar sind.

Die Druckschrift FR 2864700 A1 zeigt ein Verfahren zur Umhüllung einer elektronischen Einheit eines Sensors und eines entsprechenden Sensors. Dabei wird ein vorgefertigtes Kunststoffbauteil verwendet, in das die elektronische Einheit eingebaut wird.

Die Druckschrift EP 0694766 A1 zeigt ein Herstellungsverfahren eines Sensors einer physikalischen und elektrischen Größe. Dabei wird ebenfalls ein vorgefertigtes Hüllelement verwendet, in das der Sensor eingesetzt wird.

Die Druckschrift WO 2005/080922 A2 zeigt einen Sensorhalter zum Lagern eines Sensorbauteiles, insbesondere eines Hall-Sensors, mit einer länglichen Halteeinrichtung, an deren erstem axialen Ende das Sensorbauteil gelagert ist und an deren zweitem axialen Ende ein Anschlusskabel heranführbar ist.

Die Druckschrift DE 196 12 765 A1 zeigt einen Sensor und ein Verfahren zu dessen Herstellung vorgeschlagen. Der Sensor dient zur Erfassung von Ortsverschiebungen, Bewegungsgeschwindigkeiten oder Drehzahlen eines Encoders und umfasst ein elektrische Bauteile aufnehmendes Gehäuse mit einem ersten Gehäuseteil aus Kunststoff, welcher von einem zweiten, in einem Spritzgießvorgang ebenfalls aus Kunststoff erzeugten Gehäuseteil zumindest teilweise umhüllt ist.

Die Druckschrift DE 196 53 639 A1 zeigt Eine Vorrichtung zur Messung einer Drehbewegung und zur Erzeugung eines elektrischen Signals, das die Drehbewegung darstellt, besteht aus einem Messwertgeber in Form einer Zahnscheibe) oder dergleichen und aus einem stationären Messwertaufnehmer.

### Offenbarung der Erfindung

Der erfindungsgemäßen Magnetfeldsensor hat demgegenüber den Vorteil, dass durch die vorgeschlagene Herstellung des Sensorkems mit der elektrischen Baugruppe e1nerseits und der Befestigungslasche andererseits entsprechend den jeweiligen Einbauverhältnissen sowohl die Geometrie als auch die Längsposition und die Winkelposition der Befestigungslasche zum Geberelement veränderbar sind, so dass unterschiedlich gestaltete Sensoren allein durch eine Verlagerung oder den Wechsel von Werkzeugeinsätzen statt des gesamten Spritzgießwerkzeugs gefertigt werden können.

Zweckmäßigerweise ist der Sensorkern im Wesentlichen zylindrisch geformt und umschließt koaxial das Ende des Anschlusskabels, welches hierdurch absolut dicht und sicher mit der elektrischen Baugruppe verbunden werden kann. Die Auswahl eines auch bei starken Temperaturschwankungen und nach langer Betriebsdauer dichten Kunststoffes kann dabei unabhängig von der Auswahl des Werkstoffes der Befestigungslasche erfolgen, welcher seinerseits insbesondere unter dem Gesichtpunkt hoher mechanischer Stabilität und exakter Positionierung speziell ausgewählt werden kann. Vorzugsweise werden für die Umhüllung des Kerns und für die Befestigungslasche unterschiedliche Polyamide verwendet, welche die vorgenannten Bedingungen erfüllen.

Hinsichtlich der Befestigung des Magnetfeldsensors hat es sich weiterhin als vorteilhaft erwiesen, wenn in die Befestigungslasche eine metallische Befestigungsbuchse eingefügt ist. Hierdurch kann insbesondere die Gefahr von Beschädigungen oder einer Lockerung der Lasche bei der Montage oder im Betrieb verhindert werden. Eine besonders exakte Positionierung des Sensors ergibt sich, wenn am Sensorkern zusätzliche Zentrierelemente angebracht sind, vorzugsweise in der Form von symmetrisch angeordneten Zentrierrippen am Umfang einer Zentrierhülse. Zur Änderung der Position des Sensors können die Rippen jedoch auch unsymmetrisch angeordnet sein oder unterschiedliche Höhen besitzen. Dabei kann eine zusätzliche äußere Abdichtung des Sensors realisiert werden, wenn die Zentrierhülse an ihrem Umfang eine Nut zur Aufnahme eines Dichtrings aufweist. Weitere Einzelheiten und vorteilhafte Ausgestaltungen der Erfindung ergeben sich aus den Unteransprüchen und der Beschreibung der Ausführungsbeispiele.

### Kurze Beschreibung der Zeichnungen

Ausführungsbeispiele eines erfindungsgemäßen Magnetfeldsensors sind in den Zeichnungen dargestellt und in der nachfolgenden Beschreibung näher erläutert.

Es zeigen
- Figur 1: eine schematisierte Darstellung des Aufbaus eines erfindungsgemäßen Magnetfeldsensors,
- Figur 2: eine perspektivische Darstellung des die elektronische Baugruppe aufnehmenden Kerns mit Anschlusskabel als vorgefertigtes Bauteil des Magnetfeldsensors,
- Figur 3a: eine perspektivische Darstellung einer ersten Ausführungsform des Magnetfeldsensors und
- Figur 3b: eine perspektivische Darstellung einer weiteren Sensorbauform mit abgedichteter Zentrierhülse.

### Ausführungsformen der Erfindung

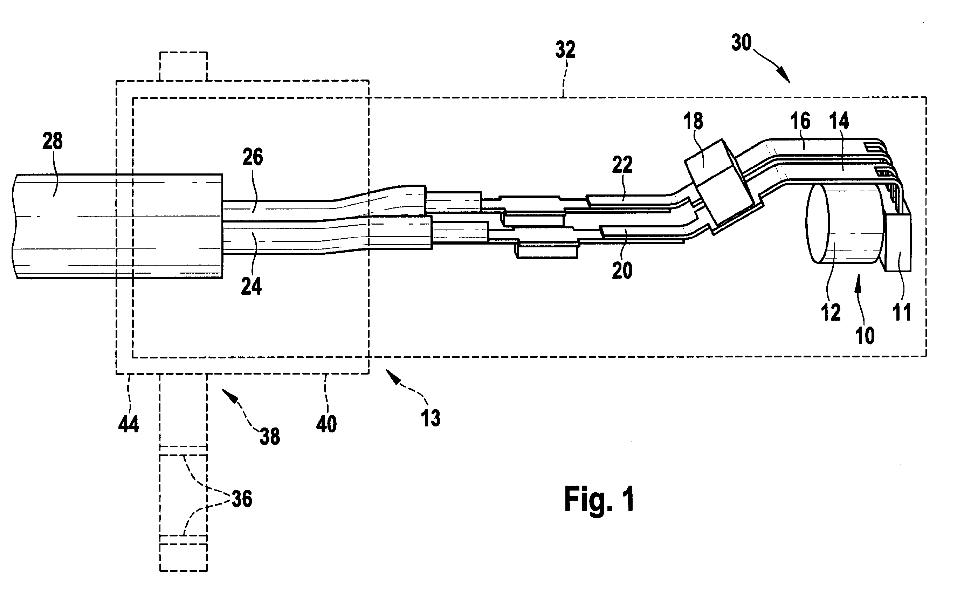

In Figur 1 ist die mit thermoplastischem Kunststoff umspritzte elektrische Baugruppe 10 eines Magnetfeldsensors 13 in der Ausführung als Drehzahlsensor zur Erfassung der Raddrehung eines Kraftfahrzeuges dargestellt. Diese enthält stirnseitig einen IC-Baustein 11 mit einem Sensorelement und einer integrierten Schaltung für die Aufbereitung der Messsignale und die Messwertausgabe. Das Magnetfeld zur Erzeugung der Messsignale wird von einem zylindrischen Permanentmagneten 12 bereitgestellt, welcher unmittelbar hinter zu dem IC-Baustein 11 angeordnet ist. Zwei Leiterbahnen 14 und 16 der integrierten Schaltung 11 sind zum Abbau von Signalspitzen durch einen Kondensator 18 überbrückt und durch Crimpverbindungen 20 und 22 mit Anschlussleitungen 24 und 26 eines Kabels 28 verbunden, dessen vorderes Ende zusammen mit den Leitungen 24 und 26, dem Kondensator 18, dem Permanentmagneten 12 und der integrierten Schaltung 11 zum fertigen, hinsichtlich Aufbau und Wirkungsweise bekannten Magnetfeldsensor mit Kunststoff umspritzt ist. Die einzelnen Teile der Kunststoffumspritzung sind in Figur 1 durch gestrichelte Linien angedeutet und in den folgenden Figuren näher erläutert.

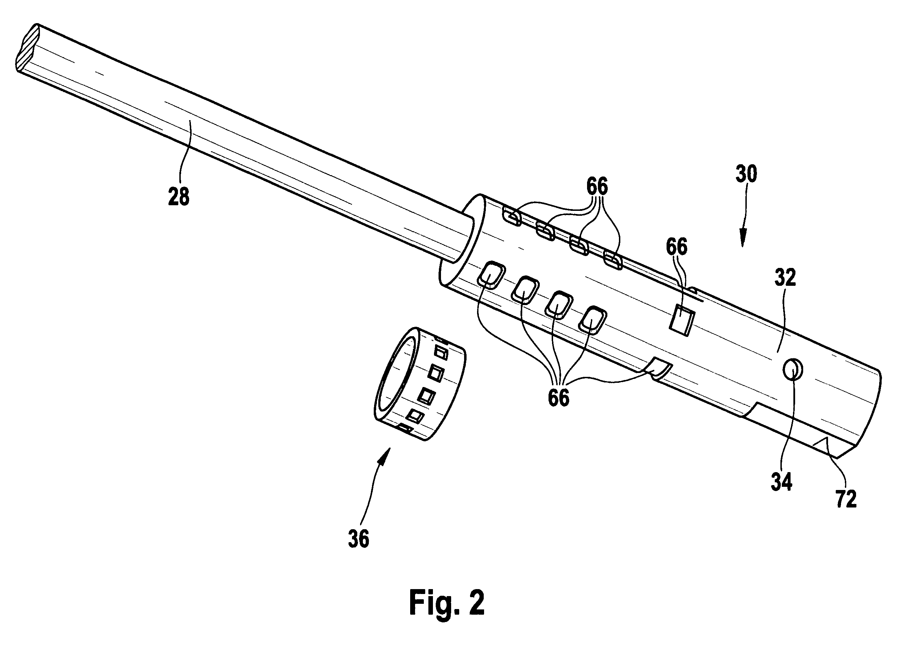

Figur 2 zeigt in perspektivischer Darstellung den Kern 30 des Sensors, welcher in einer gegen Umwelteinflüsse dichten, zylindrischen Umspritzung 32 die mit dem Anschlusskabel 28 verbundene elektrische Baugruppe 10 enthält. Eine Bohrung 34 markiert dabei die Position des IC-Bausteins 11 der elektrischen Baugruppe 10 als sensierendes Element, nach welcher der Magnetfeldsensor 13 bei der Montage ausgerichtet wird, in dieser Ausführung zu der seitlichen Lesefläche 72 hin. Figur 2 zeigt weiterhin noch eine metallische Buchse 36, welche in der Position dargestellt ist, in der sie in einem getrennten Spritzvorgang mit dem Kern 30 verbunden wird. Mehrere Aussparungen 66 auf der Oberfläche des Kerns dienen hierbei der sicheren Verbindung mit der Befestigungslasche 38.

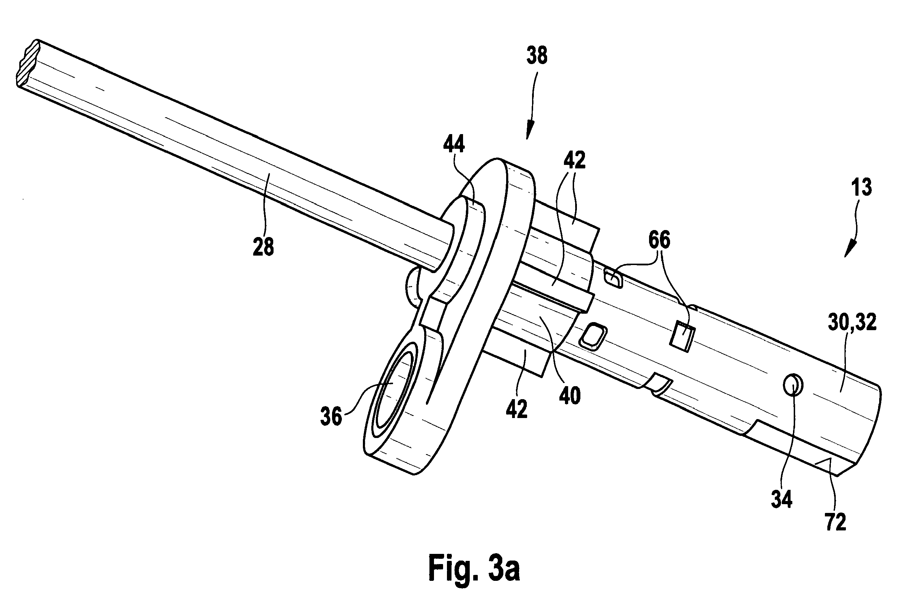

Figur 3a zeigt in perspektivischer Darstellung den fertigen Magnetfeldsensor 30 mit der Befestigungslasche 38, welche in einer vorgebbaren Längs- und Winkelposition an den Kern 30 angespritzt ist. Eine Bohrung 34 dient dabei zur Positionierung des Kerns in einem Spritzgießwerkzeug, in welchem die Befestigungslasche 38 in der für die Montage des Sensors 13 vorgegebenen Position angespritzt wird.

In die Befestigungslasche 38 ist die aus Figur 2 ersichtliche metallische Buchse 36 eingespritzt, um die Stabilität der Sensorbefestigung zu erhöhen. Die von der Befestigungslasche 38 überdeckten Aussparungen 66 sichern dabei einen formschlüssigen festen Sitz der Lasche auf dem Kern 30. Außerdem ist an die Befestigungslasche eine den Kern 30 teilweise überdeckende Zentrierhülse 40 angespritzt, welche vier gleichmäßig am Umfang der Zentrierhülse verteilte Rippen 42 aufweist, mit denen der gesamte Sensor 13 bei der Montage spielfrei zentriert wird. Weiterhin ist an die Befestigungslasche 38, der Zentrierhülse 40 gegenüberliegend, noch ein Ringflansch 44 angespritzt, welcher den Übergang vom Kabel 28 zu dem Kern 30 und der Befestigungslasche 38 stabilisiert.

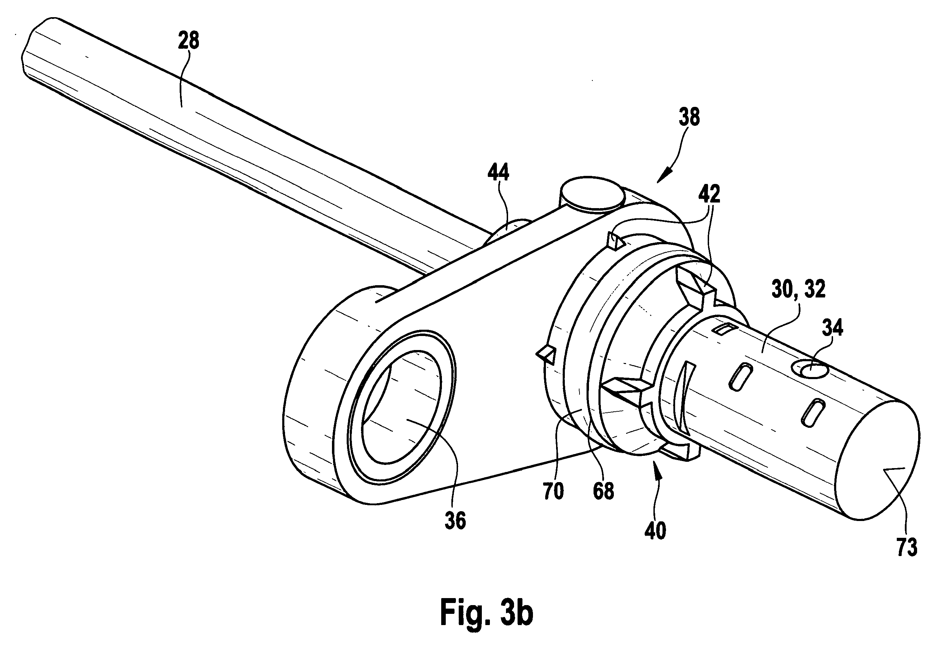

Die unterschiedlichen Positionierungsmöglichkeiten der Befestigungslasche 38 auf dem Kern 30 sind bei einem Vergleich der Figuren 3a und 3b erkennbar. Während in Figur 3a die Befestigungslasche 38 an dem kabelseitigen Ende der Kunststoffumspritzung 32 des Kerns 30 angeordnet ist sitzt sie bei der Anordnung gemäß Figur 3b weiter in der Mitte des Kerns 30 und bestimmt so eine andere Funktionslänge des Sensors. Außerdem liegt die Lesefläche 73 bei der Ausführung des Sensors gemäß Figur 3b an dessen Stirnseite. Ein weiterer Unterschied in der Ausführung gemäß Figur 3b besteht in der Gestaltung der Geometrie der Zentrierhülse 40. Diese ist zur Abdichtung einer Montageöffnung in einem nicht dargestellten Bauteil, beispielsweise in einem Radlager oder einem Getriebegehäuse, mit einer Nut 68 versehen, in welcher eine Dichtung 70 in Form eines O-Rings angeordnet ist. Die Abmessungen der Befestigungslasche 38 sind grundsätzlich variabel und können den Einbauverhältnissen des Sensors angepasst werden, ebenso wie die Form der Buchse 38, welche beispielsweise auch oval ausgebildet werden kann zur Erhöhung der Einbautoleranz und/oder zur Verringerung der Vielfalt der Laschengeometrien. Im Übrigen sind gleiche Teile mit gleichen Bezugszeichen wie in Figur 3a versehen.

## Patentansprüche

1. Magnetfeldsensor, insbesondere Drehzahl- und/oder Drehrichtungssensor für die Raddrehung oder für den Triebstrangeines Kraftfahrzeuges, mit einer elektrischen Baugruppe (10), welche elektrisch und mechanisch mit dem Ende eines Anschlusskabels (28) verbunden und mit einer Befestigungslasche (38) versehen ist, wobei die elektrische Baugruppe (10) und das Ende des Anschlusskabels (28) mit Kunststoff umspritzt sind und einen Kern (30) bilden, wobei die elektrische Baugruppe (10) einen IC-Baustein (11) mit einem Sensorelement und einer integrierten Schaltung für die Aufbereitung der Messsignale und die Messwertausgabe enthält, **dadurch gekennzeichnet, dass** der Kern (30) zylindrisch ausgebildet und gegenüber Umwelteinflüssen dicht ist und das koaxiale Ende des Anschlusskabels (28) umschließt, wobei auf den dichten Kern (30) die Befestigungslasche (38) in einer vorgebbaren Längs- und/oder Winkelposition zusammen mit einer metallischen Buchse in einem getrennten Spritzvorgang mit dem Kern verbunden ist, so dass in die Befestigungslasche (38) eine metallische Befestigungsbuchse (36) eingefügt ist.

2. Magnetfeldsensor nach einem der vorhergehenden Ansprüche, **dadurch gekennzeichnet, dass** die Befestigungslasche (38) eine Zentrierhülse (40) für den Sensor (13) aufweist.

3. Magnetfeldsensor nach Anspruch 2, **dadurch gekennzeichnet, dass** die Zentrierhülse. (40) an ihrem Umfang symmetrisch angeordnete Zentrierrippen (42) aufweist.

4. Magnetfeldsensor nach Anspruch 2, **dadurch gekennzeichnet, dass** die Positionierung des Sensors (13) durch die Winkellage und/oder die Höhe der zentrierrippen (42) veränderbar ist.

5. Magnetfeldsensor nach einem der Ansprüche 2 bis 4, **dadurch gekennzeichnet, dass** die Zentrierhülse (40) an ihrem Umfang eine Nut (68) zur Aufnahme eines Dichtrings (70) aufweist.

6. Magnetfeldsensor nach einem der vorhergehenden Ansprüche, **dadurch gekennzeichnet, dass** die Umhüllung (32), des Kerns (30) und die Befestigungslasche (38) aus unterschiedlichen Kunststoffen bestehen.

7. Magnetfeldsensor nach einem der vorhergehenden Ansprüche, dadurch gekenntzeichnet, dass die Umhüllung des Kerns (30) und die Befestigungslasche (38) aus unterschiedlichen Polyamiden bestehen.

8. Magnetfeldsensor nach einem der vorhergehenden Ansprüche, **dadurch gekennzeichnet dass** der Kern (30) auf seiner Oberfläche eine Struktur (66) zur Arretierung der Befestigungslasche (38) besitzt.

9. Magnetfeldsensor nach Anspruch 8, **dadurch gekennzeichnet, dass** der Kern (30) auf seiner Oberfläche Aussparungen (66) zur Arretierung der Befestigungslasche (38) besitzt.

10. Magnetfeldsensor nach einem der vorhergehenden Ansprüche, **dadurch gekennzeichnet, dass** die Befestigungslasche (38) in einer vorgebbaren Längs- und/oder Winkelposition angespritzt ist.

## Claims

1. Magnetic field sensor, in particular rotational speed sensor and/or rotational direction sensor for the wheel rotation or for the drive train of a motor vehicle, having an electrical subassembly (10) which is electrically and mechanically connected to the end of a connection cable (28) and is provided with a fastening lug (38), the electrical subassembly (10) and the end of the connection cable (28) being encapsulated with plastic by injection-moulding and forming a core (30), the electrical subassembly (10) containing an IC module (11) with a sensor element and an integrated circuit for conditioning the measurement signals and outputting measured values, **characterized in that** the core (30) is cylindrical and is impervious to environmental influences and surrounds the coaxial end of the connection cable (28), the fastening lug (38) on the impervious core (30) being connected, together with a metal bushing, to the core in a predefinable longitudinal and/or angular position in a separate injection-moulding process, with the result that a metal fastening bushing (36) is inserted into the fastening lug (38).

2. Magnetic field sensor according to one of the preceding claims, **characterized in that** the fastening lug (38) has a centring sleeve (40) for the sensor (13).

3. Magnetic field sensor according to Claim 2, **characterized in that** the centring sleeve (40) has centring ribs (42) which are symmetrically arranged on its circumference.

4. Magnetic field sensor according to Claim 2, **characterized in that** the positioning of the sensor (13) can be changed by the angular position and/or the height of the centring ribs (42).

5. Magnetic field sensor according to one of Claims 2 to 4, **characterized in that** the centring sleeve (40) has a groove (68) for accommodating a sealing ring (70) on its circumference.

6. Magnetic field sensor according to one of the preceding claims, **characterized in that** the sheath (32) of the core (30) and the fastening lug (38) consist of different plastics.

7. Magnetic field sensor according to one of the preceding claims, **characterized in that** the sheath of the core (30) and the fastening lug (38) consist of different polyamides.

8. Magnetic field sensor according to one of the preceding claims, **characterized in that** the core (30) has a structure (66) for locking the fastening lug (38) on its surface.

9. Magnetic field sensor according to Claim 8, **characterized in that** the core (30) has recesses (66) for locking the fastening lug (38) on its surface.

10. Magnetic field sensor according to one of the preceding claims, **characterized in that** the fastening lug (38) is injection-moulded on in a predefinable longitudinal and/or angular position.

## Revendications

1. Détecteur de champ magnétique, notamment détecteur de vitesse de rotation et/ou de sens de rotation pour la rotation des roues ou pour la chaîne motrice d'un véhicule automobile, comprenant un sous-ensemble électrique (10) qui est relié électriquement et mécaniquement avec l'extrémité d'un câble de raccordement (28) et qui est muni d'une éclisse de fixation (38), le sous-ensemble électrique (10) et l'extrémité du câble de raccordement (28) étant surmoulés dans une matière plastique et formant un noyau (30), le sous-ensemble électrique (10) contenant un composant CI (11) avec un élément de détection et un circuit intégré pour le conditionnement des signaux de mesure et la délivrance d'une valeur mesurée, **caractérisé en ce que** le noyau (30) est réalisé sous forme cylindrique et est hermétique aux influences de l'environnement et entoure l'extrémité coaxiale du câble de raccordement (28), l'éclisse de fixation (38) sur le noyau (30) hermétique étant reliée avec le noyau dans une position longitudinale et/ou angulaire pouvant être prédéfinie conjointement avec une douille métallique lors d'une opération d'injection séparée, de sorte qu'une douille de fixation métallique (36) soit incluse dans l'éclisse de fixation (38).

2. Détecteur de champ magnétique selon l'une des revendications précédentes, **caractérisé en ce que** l'éclisse de fixation (38) présente un manchon de centrage (40) pour le détecteur (13).

3. Détecteur de champ magnétique selon la revendication 2, **caractérisé en ce que** le manchon de centrage (40) présente sur son pourtour des nervures de centrage (42) disposées de manière symétrique.

4. Détecteur de champ magnétique selon la revendication 2, **caractérisé en ce que** le positionnement du capteur (13) peut être modifié par la position angulaire et/ou la hauteur des nervures de centrage (42).

5. Détecteur de champ magnétique selon l'une des revendications 2 à 4, **caractérisé en ce que** le manchon de centrage (40) présente sur son pourtour une rainure (68) pour accueillir une bague d'étanchéité (70).

6. Détecteur de champ magnétique selon l'une des revendications précédentes, **caractérisé en ce que** le gainage (32) du noyau (30) et l'éclisse de fixation (38) se composent de matières plastiques différentes.

7. Détecteur de champ magnétique selon l'une des revendications précédentes, **caractérisé en ce que** le gainage du noyau (30) et l'éclisse de fixation (38) se composent de polyamides différents.

8. Détecteur de champ magnétique selon l'une des revendications précédentes, **caractérisé en ce que** le noyau (30) possède sur sa surface une structure (66) pour bloquer l'éclisse de fixation (38).

9. Détecteur de champ magnétique selon la revendication 8, **caractérisé en ce que** le noyau (30) possède sur sa surface des évidements (66) pour bloquer l'éclisse de fixation (38).

10. Détecteur de champ magnétique selon l'une des revendications précédentes, **caractérisé en ce que** l'éclisse de fixation (38) est surmoulée dans une position longitudinale et/ou angulaire pouvant être prédéfinie.
